# EUROPÄISCHE PATENTANMELDUNG

(11) **EP 1 383 175 A1**
(43) Veröffentlichungstag der Anmeldung: **21.01.2004**
(21) Anmeldenummer: 02405611.1
(22) Anmeldetag: 16.07.2002
(51) Int. Cl.: H01L 33/00, H01L 31/0203

(54) **Optisches chipmodul**

(71) Anmelder: ABB RESEARCH LTD., 8050 Zürich (CH)
(72) Erfinder: Prêtre, Philippe, 5405 Baden-Datlwil (CH); Engelhardt, Kai, 8063 Zürich (CH); Masa, Peter, 2208 Les Hauts-Genèveys (CH); Heitger, Friedrich, 3004 Bern (CH); Sharp, Anthony, SG19 2DX Polton (GB)
(74) Vertreter: ABB Patent Attorneys

(57) **Zusammenfassung**

Für optische Chipmodule (1), insbesondere optische Sensormodule (1), lichtemittierende Dioden (1) oder Laserdioden (1), wird ein neuartiges modulares Chipgehäuse (3-5; 30, 50) offenbart. Bisher werden optische Chipmodule (1) in transparentem "Clearmold Package" direkt vergossen. Erfindungsgemäss ist ein Gehäuse (3-5; 30, 50) vorhanden, das ein erstes, separat vom Chipelement (2) hergestelltes Gehäuseteil (3; 30, 50) mit Abbildungslinse (4) aufweist und das durch Montagemittel (7-9) mit dem Chipelement (2) verbunden ist. Ausführungsbeispiele betreffen u.a.: ein zweites Gehäuseteil (5) mit Aperturblende (5) oder Aperturblende (50) integriert im ersten Gehäuseteil (30, 50); Wechseloptik durch Austauschbarkeit des ersten Gehäuseteils (3; 30, 50); und/oder Luftspalt zwischen transparent vergossenem Chipelement (2) und Linse (4). Vorteilhaft sind u. a.: Chipschutz, Linse (4) und Blende (5, 50) integriert in einem Gehäuse (3-5; 30, 50) und separat voneinander optimierbar; sowie Verschmutzungstoleranz der Linse (4) durch Überhöhung des transparenten Vergusses (2d, 8d) und durch Beabstandung der Linse (4) zum Chipelement (2).

## Beschreibung

### TECHNISCHES GEBIET

Die vorliegende Erfindung bezieht sich auf das Gebiet der Herstellung und insbesondere Verpackung ("Packaging") optischer Chipkomponenten. Sie geht aus von einem optischen Chipmodul gemäss der Präambel des unabhängigen Anspruchs.

### STAND DER TECHNIK

Bei heutigen optischen Chips, wie z. B. LEDs ("Light Emiting Diodes"), LDs ("Laser Diodes"), optischen Sensorchips oder verwandten Chips, befindet sich der eigentliche Siliziumchip in einem meist durchsichtigen Gehäuse oder flachen Verguss ("Clearmold Package"). Ein Beispiel hierfür sind optoelektronische Vergussmaterialien, die unter dem Markennamen "Hysol" von der Firma Loctite vertrieben werden. Ein derartiges Vergusspackage dient dabei nicht nur zum Schutz des lichtemittierenden oder lichtempfangenden optischen Chips, sondern muss auch alle notwendigen optischen Funktionen erfüllen. So sind z. B. im gleichen Guss Linsen zur Fokussierung des emittierten oder empfangenen Lichts integriert.

Aufgrund des integralen, einteiligen Gusses mit zugleich mechanischer Schutzwirkung und optischer Abbildungseigenschaft können nicht alle Funktionen optimal oder zufriedenstellend erfüllt werden. Auch stehen nur wenige hinreichend geeignete Materialien zur Verfügung, da ein Kompromiss zwischen Haftfähigkeit, mechanischer Stabilität, geringem Schrumpf, Eignung zum Verguss von Siliziumchips und optischen Eigenschaften, wie z.B. hinreichende Transparenz und Fokussierwirkung, gesucht werden muss.

Solche Materialien sind im allgemeinen inkompatibel mit einem Standardherstellungsprozess für PCBs ("Printed Circuit Boards"), bei dem die elektronischen Komponenten auf das PCB aufgelötet werden.

Im "Clearmold Package" mit integrierter Linse steht zudem nur eine Linsenfläche, d.h. Grenzfläche von Linse zu Luft, zur Verfügung. Zudem muss der Rand der Linsenfläche die Funktion einer Aperturblende übernehmen. Dies funktioniert jedoch nur unbefriedigend, da der Übergang zwischen Linse und Nicht-Linse lediglich ein Übergang zwischen polierter und matter Fläche ist.

### DARSTELLUNG DER ERFINDUNG

Aufgabe der vorliegenden Erfindung ist es, für optische Chipmodule der genannten Art eine verbesserte Verpackung anzugeben. Diese Aufgabe wird erfindungsgemäss durch die Merkmale des unabhängigen Anspruchs gelöst.

Die Erfindung besteht in einem optischen Chipmodul, insbesondere geeignet für lichtemittierende Dioden, Laserdioden oder optische Sensoren, umfassend ein optoelektronisches Chipelement zur Lichtemission und/oder Lichtdetektion und ein zumindest teilweise optisch transparentes Gehäuse, wobei das Gehäuse ein erstes Gehäuseteil mit einem optischen Fenster für das Chipelement umfasst, das erste Gehäuseteil separat vom Chipelement hergestellt ist und Montagemittel vorhanden sind, die zur Befestigung des ersten Gehäuseteils an dem Chipelement ausgelegt sind. Durch den modularen Gehäuseaufbau können die mechanische Schutzwirkung und die optischen Eigenschaften des Chip-Gehäuses unabhängig voneinander optimiert werden. Das modulare Gehäuse ist flexibel an unterschiedliche technische Anforderungen anpassbar und ermöglicht es, sehr gute optische Abbildungseigenschaften zu erzielen. Derartige Chipmodule sind günstig herstellbar und sind besonders zum Einsatz in Verbrauchszählern für Wasser, Heisswasser, Strom, Energie, Gas und ähnlichem in Haushalten und Gewerbebetrieben geeignet.

In einem ersten Ausführungsbeispiel umfasst das Gehäuse ein zweites Gehäuseteil, das als Aperturblende für das optische Fenster und/oder als seitlicher Lichtschutz für das Chipelement dient. Durch die Aperturblende werden die optischen Abbildungseigenschaften und damit die Zuverlässigkeit von Zählerauslesungen weiter verbessert.

In einem alternativen Ausführungsbeispiel weist das erste Gehäuseteil selber eine Aperturblende für das optische Fenster und/oder einen seitlichen Lichtschutz für das Chipelement auf. Dieser Aufbau zeichnet sich zusätzlich durch seine Einfachheit aus.

In einem weiteren Ausführungsbeispiel ist das optische Fenster als optische Linse, insbesondere als Konvexlinse, ausgebildet. Dies hat den Vorteil, dass Licht gebündelt und damit eine Lichtemission oder Lichtdetektion durch das optische Chipmodul optimiert werden kann.

Das Ausführungsbeispiel gemäss Anspruch 5 hat den Vorteil, dass Wechseloptiken für spezielle Anwendungen bereitgestellt werden können und die Wechseloptiken auf sehr einfache und billige Weise realisierbar sind.

Das Ausführungsbeispiel gemäss Anspruch 6 hat den Vorteil, dass die optische Linse des ersten Gehäuseteils zwei optisch brechende Grenzflächen zu Luft und dadurch eine verbesserte Brechkraft und die Korrektur von Abbildungsfehlern ermöglicht.

Weitere Ausführungen, Vorteile und Anwendungen der Erfindung ergeben sich aus abhängigen Ansprüchen sowie aus der nun folgenden Beschreibung und den Figuren.

### KURZE BESCHREIBUNG DER ZEICHNUNGEN

Es zeigen:
- Fig. 1: einen erfindungsgemässen optischen Chip mit modularem Gehäuse in räumlicher Einzelteil- und Gesamtdarstellung;
- Fig. 2: ein weiteres Ausführungsbeispiel des erfindungsgemässen Optikchips.
In den Figuren sind gleiche oder verwandte Teile mit gleichen oder verwandten Bezugszeichen versehen.

### WEGE ZUR AUSFÜHRUNG DER ERFINDUNG

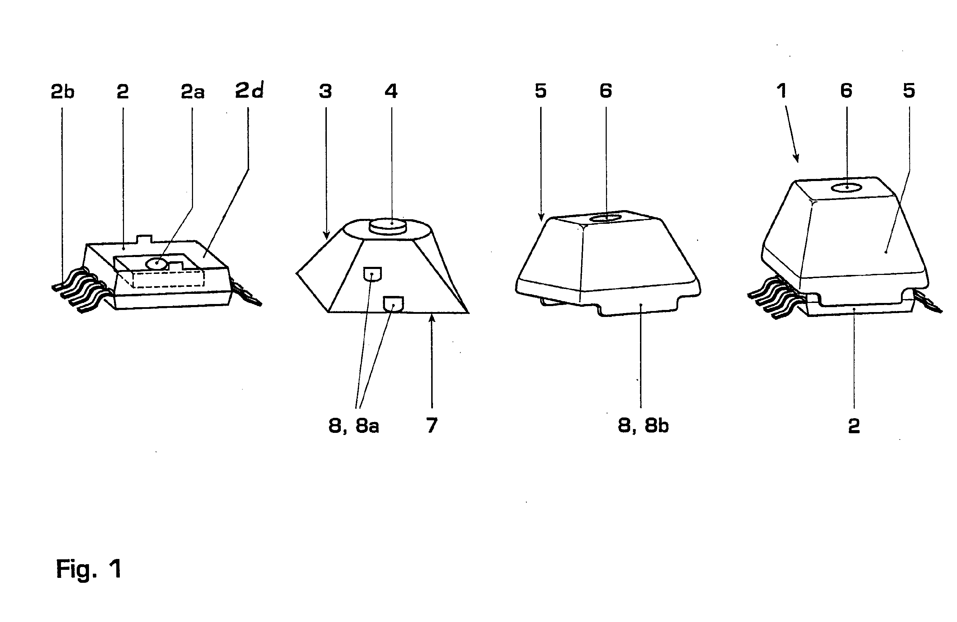

Fig. 1 zeigt einen optischen Sensor-Chip 1 oder allgemein ein optisches Chipmodul 1. Der optische Chip 1 umfasst ein optoelektronisches Chipelement 2, beispielsweise ein Lichtemissionschip 2 oder Lichtdetektorchip 2, ausgeführt als Galliumarsenidchip, Siliziumchip oder aus anderen Halbleitermaterialien. Das Chipmodul 2 besitzt eine lichtemittierende oder lichtdetektierende Fläche 2a und ist über elektrische Leitungen 2b anschliessbar. Erfindungsgemäss ist ein separat hergestelltes erstes Gehäuseteil 3 vorhanden, das eine Linse 4 für die optische Sende- oder Detektionsfläche 2b aufweist, und es sind Montagemittel 7-9 zur Befestigung des ersten Gehäuseteils 3; 30, 50 an dem Chipelement 2 vorhanden.

Der erfindungsgemäss verpackte optische Chip 1 kann z. B. im Bereich der Auslesung mechanischer Zählerrollen in Verbrauchszählern eingesetzt werden. Das modulare Gehäuse-Package 3-5; 30, 50 bietet dabei nicht nur mechanischen und chemischen Schutz für das Chipelement 2, sondern auch ausgezeichnete optische Abbildungseigenschaften. Die optischen Eigenschaften sind gegenüber herkömmlichen transparenten Vergüssen ("Clearmold-Package") von Chipelementen 2 deutlich verbessert. Das modulare Gehäuse 3-5; 30, 50 vereint somit Chipschutz, Linse oder Linsen 4, Blende oder Blenden 5 und seitlichen Lichtschutz und ist einfach herstellbar und montierbar.

Allgemein kann die Linse 4 auch ein optisches Fenster 4, gegebenenfalls mit vorggebbaren spektralen Eigenschaften, sein. Vorteilhafterweise ist das erste Gehäuseteil 3; 30, 50 mitsamt dem optischen Fenster 4 oder das optische Fenster 4 separat im Chipmodul 1 austauschbar. Insbesondere kann eine Wechseloptik dadurch realisiert sein, dass mehrere erste Gehäuseteile 3; 30, 50 mit unterschiedlichen optischen Linsen 4 vorhanden sind. Eine solche Wechseloptik hat den Vorteil, dass die Optik im Spritzguss hergestellt sein kann und damit auch in relativ niedrigen Stückzahlen zu vernünftigen Kosten produzierbar ist. Dabei kann ein optional vorhandenes "Clearmold Package" des Chipelements 2 unverändert bleiben und standardmässig in grossen Stückzahlen zu niedrigen Kosten hergestellt sein.

Das erste Gehäuseteil 3 ist mit Vorteil als pyramidenstumpfförmiges Distanzstück 9 ausgelegt, das einen gewünschten Abstand zwischen der optischen Fläche 2a und der Linse 4 bewirkt. Darüberhinaus kann das erste Gehäuseteil 3 Zentriernoppen 8a oder Zentrierlöcher 8a zur selbstzentrierenden Montage auf dem Chipelement 2 aufweisen.

Mit Vorteil ist ein zweites Gehäuseteil 5 vorgesehen, das als Aperturblende 5 für das optische Fenster 4 und/oder als seitlicher Lichtschutz 5 für das Chipelement 2 dient. Das zweite Gehäuseteil 5 kann über das erste Gehäuseteil 3 gestülpt werden, so dass es dieses mechanisch und optisch schützt. Das zweite Gehäuseteil 5 besitzt eine Öffnung oder Apertur 6 für den Lichtzutritt durch das optische Fenster 4 zur optisch aktiven Fläche 2b des Chipmoduls 1. Als Zentriermittel 8 können vertikal verlaufende Stege 8b vorhanden sein, die in das Chipelement 2 oder alternativ (nicht dargestellt) in das erste Gehäuseteil 3 eingreifen. Auf der rechten Seite von Fig. 1 ist das resultierende verpackte Chipmodul 1 mit dem modular zusammengesetzten Gehäuse 3-5 im zusammengebauten Zustand dargestellt.

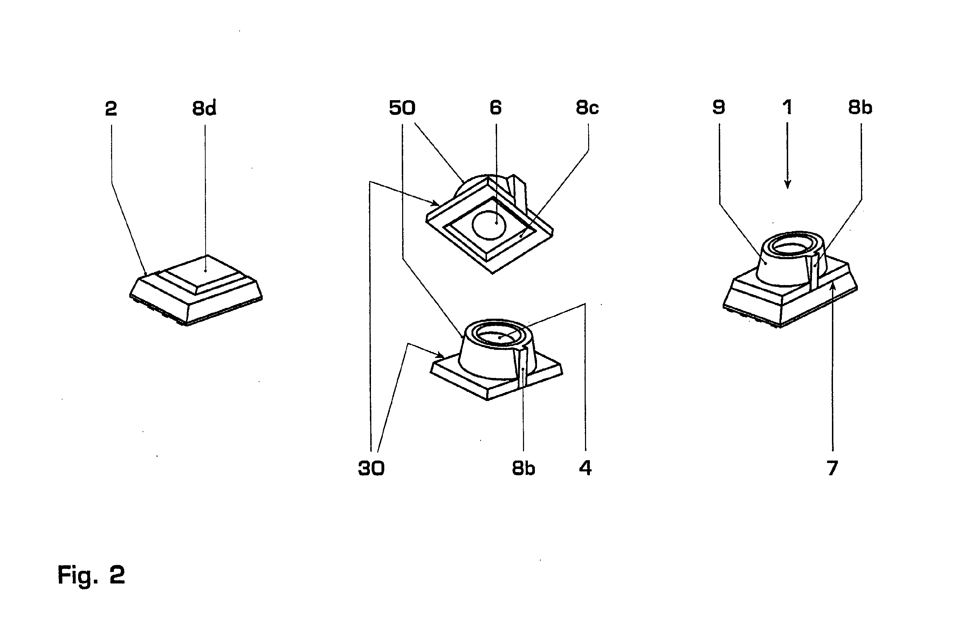

Fig. 2 zeigt eine weiter vereinfachte Variante zu Fig. 1. Hier sind die Funktionen des ersten Gehäuseteils 3, wie Dichtigkeit gegen Verschmutzung, Beabstandung der Linse 4 und Linsenfassung, und des zweiten Gehäuseteils 3, wie Bereitstellung einer Aperturblende 50 und eines seitlichen Lichtschutzes 50, in einem einzigen Bauteil 30, 50 vereint. Die transversale Zentrierung geschieht mit Hilfe zweier ineinandergreifender Pyramidenstümpfe 8d, 8c, von denen einer 8d auf dem Chipelement 2 und der andere 8c auf einer Unterseite des ersten und einzigen Gehäuseteils 30, 50 angeordnet ist. Zur Sicherung gegen einen unbeabsichtigt verdrehten Einbau, z. B. bei nicht rotationssymmetrischen Linsen 4, kann ein vertikal verlaufender Zentriersteg 8b vorhanden sein, der beim Aufsetzen des Gehäuseteils 30 leicht in eine gewünschte Orientierung gebracht werden kann.

Im Beispiel gemäss Fig. 2 ist das einmodulige Gehäuse 30, 50 so ausgelegt, dass ein Luftspalt zwischen dem optisch transparenten Verguss 8d des Chipelements 2 und dem optischen Fenster 4 des ersten Gehäuseteils 3 vorhanden ist. Dadurch ist die Brechkraft der Linse 4 erhöht und Abbildungskorrekturen sind an zwei Linsenflächen und damit einfacher durchführbar. Der Luftspalt ist auch in der Ausführungsform gemäss Fig. 1 zwischen dem Verguss 2d des Chipelements 2 und dem optischen Fenster 4 des ersten Gehäuseteils 3 realisierbar. Der optisch transparente Verguss 2d oder 8d des Chipelements 2 ist - im Gegensatz zu herkömmlichen, flachen "Clearmold" Vergüssen - relativ dick ausgeführt, insbesondere gemäss Fig. 2 in Form eines Pyramidenstumpfs 8d. Der Pyramidenstumpf 8d dient ausser zur Zentrierung des ersten Gehäuseteils 30, 50 auf dem Chipelement 2 auch zur Reduktion der Schmutzempfindlichkeit des Chipelements 2. Durch die Höhenerstreckung oder Vergussdicke des Pyramidenstumpfvergusses 8d (ebenso des Vergusses 2d in Fig. 1) wird nämlich eine gegenüber herkömmlichen "Clearmold" Verpackungen überhöhte optische Distanz zwischen Detektionsebene 2a (=Oberfläche 2a des Chipelements 2) und Aussenfläche oder Oberfläche des Vergusses 8d (oder 2d) geschaffen. Dadurch werden optisch störende Einflüsse von Staub- und Schmutzablagerungen auf der Aussenfläche des Vergusses 8d (oder 2d) deutlich abgeschwächt. Dies stellt einen wesentlichen Vorteil gegenüber herkömmlichen, weitgehend flachen "Clearmold" Gehäusen oder Verpackungen dar.

Für das Zusammenfügen der Einzelteile 2, 3, 5 oder 2, 30, 50 sind Montagemittel 7-9 vorhanden. Diese umfassen insbesondere Befestigungsmittel 7, die zur dauerhaften Montage geeignet sind, z. B. Klebeflächen 7 oder Ultraschallverschweissflächen 7, oder die zur reversiblen Montage des ersten Gehäuseteils 3; 30, 50 am Chipelement 2 und gegebenenfalls eines zweiten Gehäuseteils 5 am Chipelement 2 oder am ersten Gehäuseteil 3; 30, 50 geeignet sind. Beim Verkleben wird einfach etwas Leim auf den unteren Rand 7 der Pyramide 3 appliziert. Dieser verteilt sich dann gleichmässig auf dieser Grundfläche 7, ohne auf die obere optische Fläche oder Linse 4 gelangen zu können. Bei reversibler Gehäusemontage sind lösbare Befestigungsmittel 7, wie z. B. Klemmen, Verschlüsse o. ä., verwendbar.

Die Montagemittel 7-9 können auch Zentriermittel 8 zur selbstzentrierenden Montierbarkeit des ersten Gehäuseteils 3; 30, 50 auf dem Chipelement 2 und/oder des zweiten Gehäuseteils 5 auf dem ersten Gehäuseteil 3 aufweisen derart, dass eine vorteilhafte optische Ausrichtung des optischen Fensters 4 und/oder einer Aperturblende 5, 50 relativ zum Chipelement 2 erzielbar ist. Insbesondere handelt es sich bei den Zentriermitteln 8 um Zentriernoppen 8a oder Zentrierlöcher 8a, einen Zentriersteg 8b und/oder um die bereits bei Fig. 2 erwähnten Zentrierpyramidenstümpfe 8d, 8c, die ineinandergreifen.

Ferner können die Montagemittel 7-9 Distanzmittel 9 aufweisen, die für eine vorgebbare Beabstandung des Chipelements 2 vom optischen Fenster 4 sorgen. Insbesondere sind die Distanzmittel 9 durch ein pyramidales erstes und gegebenenfalls ein pyramidales zweites Gehäuseteil 3, 30, 50; 5 implementiert.

Aufgrund der Beabstandung liegt eine Verschmutzung auf der Linse 4 nicht mehr im Bereich der Bildebene 2a, sondern der Linsen- oder Fourierebene 4 des Abbildungssystems. Die Linsenverschmutzung bewirkt somit lediglich eine relativ unbedenkliche Filterung des räumlichen Fourierspektrums und wirkt kaum noch bildverschlechternd.

Ein wesentlicher Vorteil des modularen Gehäuses 3-5; 30, 50 besteht darin, dass das optische Fenster 4 aus einem optischen Standardpolymer, insbesondere aus Plexiglass (PMMA), herstellbar ist. PMMA ist für Linsen 4 sehr geeignet, jedoch zu wenig hitzebeständig für einen Standardherstellungsprozess von PCBs ("printed circuit boards"), bei dem das optoelektronische Chipelement 2 in einem Lötofen auf das elektrische PCB aufgelötet wird. Zudem kann der Verguss 2d, 8d des Chipelements 2 aus einem für Chip-Verguss geeigneten Material hergestellt sein (z. B. wie von "Clearmold" Verpackungen bekannt). Der Chip-Verguss 2d, 8d kann insbesondere kompatibel mit einem Standardherstellungsprozess für PCBs gewählt sein.

### BEZUGSZEICHENLISTE

- 1: optisches Chipmodul
- 2: optoelektronisches Chipelement, Lichtemissionschip, Lichtdetektorchip, Galliumarsenidchip, Siliziumchip
- 2a: lichtemittierende oder -detektierende Fläche
- 2b: elektrische Leitungen
- 2d: optisch transparenter Verguss
- 3-5, 30, 50: Gehäuse
- 3: erstes Gehäuseteil mit Linsenfassung
- 4: optisches Fenster, Linse, Konvexlinse
- 5: zweites Gehäuseteil, Aperturblende mit Lichtschutz
- 6: optische Öffnung, Apertur
- 7-9: Montagemittel
- 7: Befestigungsmittel; Klebefläche, Ultraschallverschweissfläche
- 8: Zentriermittel
- 8a: Zentriernoppen, Zentrierlöcher
- 8b: Zentriersteg, Verdrehsicherung
- 8c: Zentrierpyramidenstumpf, optisch transparenter Verguss
- 9: Distanzmittel, Pyramide
- 30: erstes Gehäuseteil mit Linsenfassung, Linse und integrierter Aperturblende
- 50: Aperturblende (im ersten Gehäuseteil integriert)

## Patentansprüche

1. Optisches Chipmodul (1), insbesondere für lichtemittierende Dioden, Laserdioden oder optische Sensoren, umfassend ein optoelektronisches Chipelement (2) zur Lichtemission und/oder Lichtdetektion und ein zumindest teilweise optisch transparentes Gehäuse (3-5; 30, 50), wobei
a) das Gehäuse (3-5; 30, 50) ein erstes Gehäuseteil (3; 30, 50) mit einem optischen Fenster (4) für das Chipelement (2) umfasst,
b) das erste Gehäuseteil (3; 30, 50) separat vom Chipelement (2) hergestellt ist und
c) Montagemittel (7-9) vorhanden sind, die zur Befestigung des ersten Gehäuseteils (3; 30, 50) an dem Chipelement (2) ausgelegt sind.

2. Optisches Chipmodul (1) nach Anspruch 1, wobei
a) das Gehäuse (3-5; 30, 50) ein zweites Gehäuseteil (5) umfasst und
b) das zweite Gehäuseteil (5) als Aperturblende (5) für das optische Fenster (4) und/oder als seitlicher Lichtschutz (5) für das Chipelement (2) dient.

3. Optisches Chipmodul (1) nach Anspruch 1, wobei das erste Gehäuseteil (30, 50) eine Aperturblende (50) für das optische Fenster (4) und/oder einen seitlichen Lichtschutz (50) für das Chipelement (2) ausweist.

4. Optisches Chipmodul (1) nach einem der vorangehenden Ansprüche, wobei das optische Fenster (4) als optische Linse (4), insbesondere als Konvexlinse (4), ausgebildet ist.

5. Optisches Chipmodul (1) nach einem der vorangehenden Ansprüche, wobei
a) das erste Gehäuseteil (3; 30, 50) mitsamt dem optischen Fenster (4) oder das optische Fenster (4) separat im Chipmodul (1) austauschbar ist und
b) insbesondere dass erste Gehäuseteile (3; 30, 50) mit unterschiedlichen optischen Linsen (4) vorhanden sind.

6. Optisches Chipmodul (1) nach einem der vorangehenden Ansprüche, wobei
a) das Chipelement (2) transparent vergossen ist und zwischen dem Verguss (2d, 8d) des Chipelements (2) und dem optischen Fenster (4) des ersten Gehäuseteils (3; 30, 50) ein Luftspalt vorhanden ist und/oder
b) ein optisch transparenter Verguss (2d, 8d) des Chipelements (2) eine Vergusshöhe aufweist, die zur Schaffung einer optischen Distanz zwischen einer Aussenfläche des Vergusses (2d, 8d) und einer Oberfläche (2a) des Chipelements (2) überhöht ist.

7. Optisches Chipmodul (1) nach einem der vorangehenden Ansprüche, wobei die Montagemittel (7-9) Befestigungsmittel (7) aufweisen, die zur dauerhaften Montage geeignet sind, insbesondere Klebeflächen (7) oder Ultraschallverschweissflachen (7), oder die zur reversiblen Montage des ersten Gehäuseteils (3; 30, 50) am Chipelement (2) und gegebenenfalls eines zweiten Gehäuseteils (5) am Chipelement (2) oder am ersten Gehäuseteil (3; 30, 50) geeignet sind.

8. Optisches Chipmodul (1) nach einem der vorangehenden Ansprüche, wobei
a) die Montagemittel (7-9) Zentriermittel (8) zur selbstzentrierenden Montierbarkeit des ersten Gehäuseteils (3; 30, 50) auf dem Chipelement (2) und/oder des zweiten Gehäuseteils (5) auf dem ersten Gehäuseteil (3) aufweisen derart, dass eine vorteilhafte optische Ausrichtung des optischen Fensters (4) und/oder einer Aperturblende (5, 50) relativ zum Chipelement (2) erzielt wird und
b) insbesondere dass die Zentriermittel (8) Zentriernoppen (8a), ein Zentriersteg (8b) und/oder ineinandergreifende Zentrierpyramidenstümpfe (8d, 8c) sind.

9. Optisches Chipmodul (1) nach einem der vorangehenden Ansprüche, wobei die Montagemittel (7-9) Distanzmittel (9), insbesondere ein pyramidales erstes und gegebenenfalls ein pyramidales zweites Gehäuseteil (3, 30, 50; 5), für eine vorgebbare Beabstandung des Chipelements (2) vom optischen Fenster (4) aufweisen.

10. Optisches Chipmodul (1) nach einem der vorangehenden Ansprüche, wobei
a) das optische Fenster (4) aus einem optischen Standardpolymer, insbesondere aus PMMA, hergestellt ist und/oder
b) ein Verguss (2d, 8d) des Chipelements (2) aus einem für Chip-Verguss geeigneten Material hergestellt ist, das insbesondere kompatibel mit einem Standardherstellungsprozess für PCBs ist.
